(19) Europäisches Patentamt
European Patent Office
Office européen des brevets

(11) **EP 2 407 339 B1**

(12) **FASCICULE DE BREVET EUROPEEN**

(45) Date de publication et mention
de la délivrance du brevet:
**12.12.2012 Bulletin 2012/50**

(21) Numéro de dépôt: **11305693.1**

(22) Date de dépôt: **06.06.2011**

(51) Int Cl.:
*B60L 7/10* (2006.01)       *B60L 11/18* (2006.01)
*H02P 3/06* (2006.01)       *H02P 6/08* (2006.01)
*H02P 25/16* (2006.01)       *H02P 25/22* (2006.01)
*H02M 7/797* (2006.01)

(54) **Dispositif électrique d'entrainement d'un équipement mécanique et procédé associé**

Vorrichtung zum elektrischen Antrieb einer mechanischen Vorrichtung und dessen Verfahren

Electrical drive device for mechanical equipment and associated method

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2010 FR 1055095**

(43) Date de publication de la demande:
**18.01.2012 Bulletin 2012/03**

(73) Titulaire: **Valeo Systèmes de Contrôle Moteur
95800 Cergy Saint Christophe (FR)**

(72) Inventeurs:
• **Bouchez, Boris
95800 CERGY LE HAUT (FR)**
• **De Sousa, Luis
95670 ERAGNY SUR OISE (FR)**

(74) Mandataire: **Cardon, Nicolas
Valeo Systèmes de Contrôle Moteur
14, avenue des Béguines
95800 Cergy St Christophe (FR)**

(56) Documents cités:
**EP-A2- 1 764 256       DE-A1- 2 109 026
US-A- 3 849 714       US-A1- 2005 275 983
US-A1- 2009 033 274**

**Description**

La présente invention concerne le domaine des dispositifs électriques destinés à entraîner des équipements mécaniques, par exemple des véhicules automobiles, utilisant un moteur électrique et permettant de récupérer une partie de l'énergie fournie par l'équipement mécanique dans certaines circonstances, par exemple lors du freinage, aussi appelé freinage régénératif, dans le cas d'un véhicule automobile.

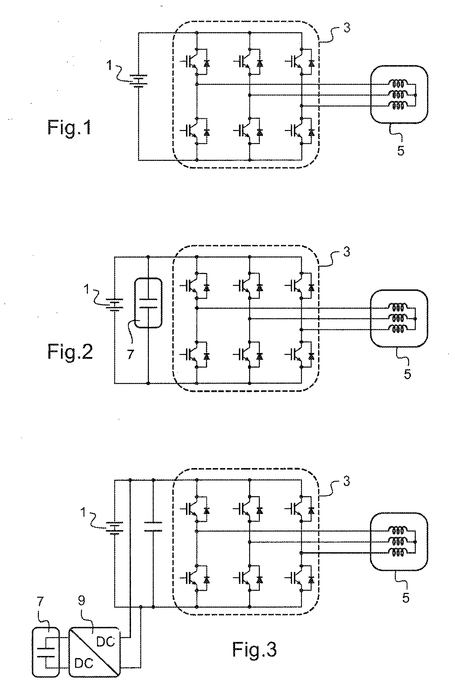

Dans l'état de la technique, les moteurs électriques sont alimentés par des batteries rechargeables haute tension 1 délivrant un courant continu à un onduleur 3 qui transforme ce courant continu en un courant alternatif permettant d'alimenter un moteur électrique 5, ce dernier assurant la mise en mouvement de l'équipement mécanique tel que représenté sur la figure 1.

De plus, le fonctionnement des moteurs électriques 5, généralement des moteurs asynchrones triphasés comme représenté sur la figure 1, permet également d'utiliser l'énergie mécanique non utilisée par l'équipement mécanique comme générateur pour recharger les batteries 1. Néanmoins, en particulier lors des trajets urbains, les véhicules effectuent des freinages brefs et violents produisant une grande quantité d'énergie pendant un temps réduit et de manière répétée dans le temps. Or, les courants intenses créés ne sont pas acceptés par les batteries 1 de l'état de la technique et les régimes transitoires ainsi créés peuvent conduire à une usure prématurée de ces batteries 1.

Pour surmonter ce problème une solution de l'état de la technique consiste en l'utilisation de super-condensateurs afin de stocker l'énergie emmagasinée lors du freinage comme décrit sur le brevet EP1241041. Les figures 2 à 5 représentent des exemples de configuration de l'état de la technique dans lesquels des super-condensateurs sont implémentés au niveau des circuits électriques d'alimentation des moteurs électriques 5.

Sur la figure 2, le super-condensateur 7 est branché en parallèle de la batterie 1. Le problème dans une telle configuration est que la gestion de l'énergie entre la batterie et le super-condensateur ne peut pas être contrôlée. Ainsi, le super-condensateur ne peut être déchargé à zéro volt ou chargé à une tension supérieure à celle de la batterie, ce qui limite l'exploitation des capacités du super-condensateur et restreint donc son intérêt.

Afin de surmonter ce problème, une possibilité est d'introduire un convertisseur de tension continu-continu (DC-DC) 9 permettant une gestion indépendante du super-condensateur tel que décrit sur la figure 3. Néanmoins, une telle configuration est onéreuse à cause du prix du convertisseur continu 9.

Certains circuits d'alimentation possèdent déjà un convertisseur élévateur de tension (aussi appelé « boost » en anglais) 11 en amont de l'onduleur 3. Cette configuration permet une optimisation du circuit d'alimentation car on contrôle l'alimentation de l'onduleur 3.

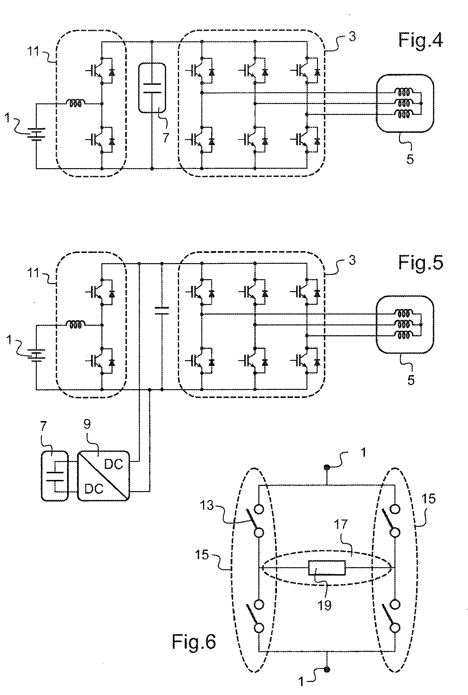

Ainsi, l'idée est de placer le super-condensateur 7 en sortie du convertisseur élévateur de tension 11 tel que décrit sur la figure 4. Cependant, cela crée une dépendance entre la tension d'alimentation de l'onduleur 3 et l'état de charge du super-condensateur 7. Ainsi, lorsque la tension d'alimentation de l'onduleur 3 est réduite, comme c'est le cas par exemple à faible vitesse, le super-condensateur 7 est alors contraint de se décharger. Par ailleurs, le super-condensateur 7 ne pourrait être complètement déchargé. Ces inconvénients peuvent être surmontés par l'ajout d'un convertisseur de tension continu (DC-DC) 9 comme représenté sur la figure 5 mais dans ce cas, comme pour la configuration présentée sur la figure 3, le coût du convertisseur 9 est très élevé.

La nécessité est donc de proposer un mode de réalisation simple et peu onéreux permettant de surmonter les inconvénients précités de l'état de la technique et notamment une exploitation optimisée de la capacité des super-condensateurs 7 pour la récupération d'énergie des moteurs électriques 5.

Ainsi, la présente invention concerne un dispositif électrique d'entraînement d'un équipement mécanique comportant un moteur à courant alternatif et un onduleur, ledit onduleur comprenant, pour chaque phase dudit moteur, une structure de pont en H comportant quatre éléments de commutation répartis sur deux bras reliant deux bornes de ladite structure de pont en H et destinée à alimenter le bobinage de ladite au moins une phase du moteur, ledit bobinage étant un bobinage à point milieu et ledit dispositif électrique comprenant également, pour chaque phase dudit moteur, au moins une unité de stockage d'énergie, notamment un super-condensateur, reliée d'une part au point milieu du bobinage de la phase concernée du moteur et d'autre part à une borne de la structure de pont en H alimentant ledit bobinage.

L'invention a encore pour objet, selon un autre de ses aspects, un dispositif électrique d'entraînement d'un équipement mécanique comportant un moteur à courant alternatif et un onduleur, ledit onduleur comprenant, pour chaque phase dudit moteur, une structure de pont en H comportant quatre éléments de commutation répartis sur deux bras reliant deux bornes de ladite structure de pont en H et destinée à alimenter le bobinage de ladite au moins une phase du moteur, ledit bobinage étant un bobinage à point milieu,
ledit dispositif électrique comprenant également au moins une unité de stockage d'énergie, notamment un super-condensateur, reliée d'une part à au moins une phase du moteur via le point milieu du bobinage de cette phase et d'autre part à une borne de la structure de pont en H alimentant ledit bobinage.

Le dispositif peut comprendre une unique unité de stockage d'énergie, notamment un unique super-condensateur, reliée, notamment directement reliée, d'une part au point milieu du bobinage de chaque phase du moteur et d'autre part à ladite borne de la structure de pont en H alimentant ledit bobinage.

En variante, le dispositif peut comprendre pour chaque phase une unité de stockage d'énergie, notamment un super-condensateur, reliée d'une part au point milieu du bobinage de ladite phase du moteur et d'autre part à ladite borne de la structure de pont en H alimentant ledit bobinage.

La borne de la structure de pont en H à laquelle l'unité de stockage d'énergie, le cas échéant le super-condensateur, est reliée peut correspondre à la borne reliée au potentiel de masse.

Le super-condensateur est par exemple un condensateur ayant une densité de puissance comprise entre 1000 et 5000 W/kg et/ou une densité d'énergie comprise entre 4 et 6 Wh/kg.

Le super-condensateur peut être un super-condensateur à double couche électrochimique.

Selon un premier exemple de mise en oeuvre de l'invention, le moteur est alimenté par une pile à combustible. La pile à combustible peut faire partie du dispositif électrique.

Selon ce premier exemple de mise en oeuvre de l'invention, lors du régime transitoire correspondant à l'arrêt de l'alimentation du moteur, l'énergie fournie par la pile à combustible peut être emmagasinée dans l'unité de stockage, notamment le super-condensateur.

Selon un deuxième exemple de mise en oeuvre de la présente invention, le dispositif électrique comprend également des moyens d'accumulation permettant d'alimenter le moteur et des moyens de contrôle de l'onduleur configurés pour permettre d'une part le chargement de l'unité de stockage d'énergie, notamment du super-condensateur lors des phases de freinage du véhicule et d'autre part le déchargement de l'unité de stockage d'énergie, notamment du super-condensateur vers le moteur lors des phases d'accélération et/ou vers les moyens d'accumulation de manière à charger les moyens d'accumulation.

Selon ce deuxième mode de mise en oeuvre de la présente invention, les moyens d'accumulation peuvent comprendre une batterie.

Un, notamment chaque, élément de commutation peut comprendre un transistor et une diode montés en parallèle.

Le transistor peut être un transistor bipolaire à porte isolée.

Le moteur à courant alternatif peut être un moteur triphasé.

Chaque borne de chaque phase du moteur peut être reliée à des éléments de commutation du pont en H, chaque phase du moteur correspondant à la charge du pont en H.

Tous les ponts en H du dispositif peuvent être identiques ou non.

La présente invention concerne également un procédé de récupération de l'énergie électrique produite par un moteur électrique de véhicule automobile dont chaque phase comprend un bobinage à point milieu et est alimentée par une structure de pont en H, dans lequel, lors des phases de freinage dudit véhicule, les éléments de commutation de la structure de pont en H sont pilotées de manière à récupérer l'énergie électrique produite dans au moins une unité de stockage d'énergie, notamment un super-condensateur, branchée entre au moins une phase du moteur, notamment une ou trois phases, via le point milieu du bobinage de cette phase et une borne de la structure de pont en H correspondant à la base des branches de la structure du pont en H.

Selon un autre aspect de la présente invention, lorsque l'unité de stockage d'énergie, notamment le super-condensateur, est chargée, les éléments de la structure en H sont pilotés de manière à décharger une partie de l'énergie de l'unité de stockage d'énergie, notamment du super-condensateur, dans une batterie.

La présente invention concerne également un procédé de restitution de l'énergie électrique emmagasinée dans au moins une unité de stockage d'énergie, notamment un super-condensateur, à un moteur électrique de véhicule automobile dont chaque phase comprend un bobinage à point milieu et est alimentée par une structure de pont en H dans lequel lors des phases d'accélération dudit véhicule, les éléments de commutation de la structure de pont en H sont pilotées de manière à utiliser en priorité l'énergie emmagasinée dans l'unité de stockage d'énergie, notamment le super-condensateur, qui est branchée entre au moins une phase du moteur, notamment une ou trois phases, via le point milieu du bobinage de cette phase et une borne de la structure de pont en H correspondant à la base des branches de la structure du pont en H.

La ou les unités de stockage d'énergie peuvent être autres que des super-condensateurs, par exemple des batteries lithium-ion.

D'autres caractéristiques et avantages de l'invention apparaîtront dans la description qui va maintenant en être faite, en référence aux dessins annexés qui en représentent, à titre indicatif mais non limitatif, un mode de réalisation possible.

Sur ces dessins:

- la figure 1 représente un exemple de réalisation d'un schéma d'un circuit électrique d'alimentation selon l'état de la technique;
- la figure 2 représente un premier exemple de réalisation d'un schéma d'un circuit électrique d'alimentation utilisant un super-condensateur selon l'état de la technique;
- la figure 3 représente un deuxième exemple de réalisation d'un schéma d'un circuit électrique d'alimentation utilisant un super-condensateur selon l'état de la technique;
- la figure 4 représente un troisième exemple de réalisation d'un schéma d'un circuit électrique d'alimentation utilisant un super-condensateur selon l'état de la technique;
- la figure 5 représente un quatrième exemple de réalisation d'un schéma d'un circuit électrique d'alimentation utilisant un super-condensateur selon l'état de la technique;

- la figure 6 représente une structure de pont en H;
- la figure 7 représente une structure de pont en H selon un mode de réalisation de la présente invention;
- la figure 8 représente un premier mode de réalisation de la présente invention;
- la figure 9 représente un deuxième mode de réalisation de la présente invention;
- la figure 10 est un schéma explicatif du fonctionnement du pont en H selon un mode de réalisation de la présente invention;

Dans la description qui va suivre, on désigne de façon générale:

- Le terme « transistor bipolaire à porte isolée « insulated gate bipolar transistor (IGBT) » en anglais » correspond à un transistor hybride, regroupant un transistor à effet de champ à grille métal-oxyde (« metal-oxyd semiconductor field effect transistor (MOSFET) » en anglais) en entrée et un transistor bipolaire en sortie

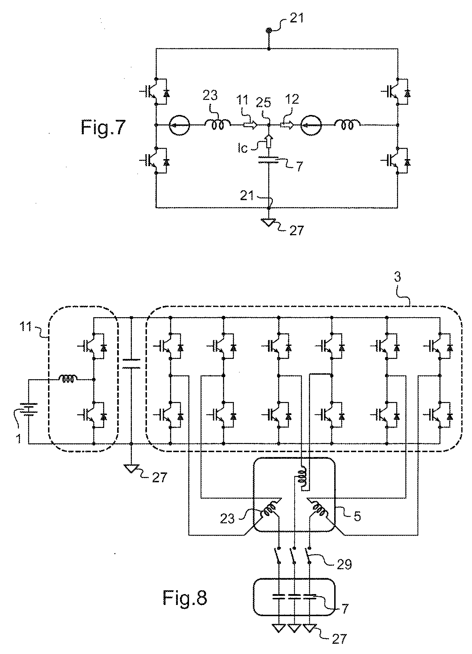

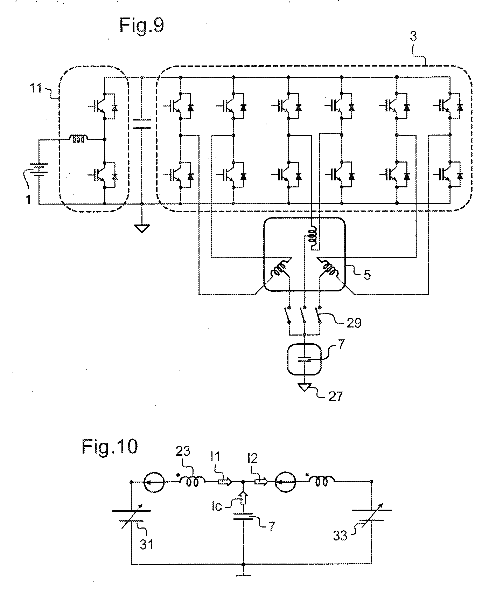

Le terme « structure de pont en H » ou « pont en H » correspond à un circuit électrique ou électronique comportant quatre éléments de commutation 13 généralement disposés schématiquement sous forme d'un H comme représenté sur la figure 6, les deux branches verticales 15 du H comprennent, chacune, deux éléments de commutation 13 disposés de part et d'autre de la branche horizontale 17 du H qui correspond à la charge 19 du pont. Dans le cas de la présente invention, cette charge 19 correspond au bobinage d'une phase d'un moteur électrique 1. De plus, les deux branches verticales 15 sont reliées à leurs extrémités au niveau des deux bornes 21 du pont. Les éléments de commutation étant généralement réalisés par un transistor monté en parallèle avec une diode comme représenté sur les figures 8 et 9, le transistor étant généralement un transistor bipolaire à porte isolée.

- Le terme « super-condensateur » correspond à un condensateur de grande capacité généralement réalisé selon le procédé de double couche électrochimique dans lequel deux électrodes poreuses, généralement en charbon actif et imprégnées d'électrolyte, sont séparées par une membrane isolante et poreuse (afin d'assurer la conduction ionique). Cela permet une densité de puissance et une densité d'énergie intermédiaires entre les batteries et les condensateurs classiques et une vitesse de restitution de l'énergie plus rapide que les batteries.

Les modes de réalisation de la présente invention consistent à utiliser un moteur électrique 5 dont le bobinage 23 de la, au moins une, phase est un bobinage à point milieu et un circuit d'alimentation du moteur électrique dont l'onduleur utilise au moins une structure de pont en H pour alimenter la, au moins une, phase, une unité de stockage d'énergie 7 étant branchée entre le point milieu 25 du bobinage et la borne 21 du pont en H correspondant à la masse 27 tel que décrit sur la figure 7. Dans ce cas, le bobinage 23 du moteur électrique 5 devient la charge 19 du pont en H.

Dans les exemples décrits, la ou les unités de stockage d'énergie 7 sont des super-condensateurs mais l'invention n'est pas limitée à un tel exemple.

La présente invention s'applique aux moteurs 5 comprenant un nombre de phases quelconques, néanmoins, dans la suite de la description, des moteurs triphasés seront décrits pour illustrer l'invention, ces moteurs étant les plus couramment utilisés notamment dans le domaine des véhicules automobile électriques.

La figure 8 représente un premier mode de réalisation d'un circuit d'alimentation d'un moteur électrique triphasé dans lequel une batterie ou pile à combustible 1 est reliée à un onduleur 3 par l'intermédiaire d'un circuit élévateur 11, l'onduleur 3 comportant trois structures de pont en H destinées à alimenter les trois phases du moteur électrique 5 schématisées par leur bobinage 23. Pour chacune des trois phases, un super-condensateur 7 est branché entre le point milieu du bobinage 23 et le potentiel de masse 27 du circuit d'alimentation. De plus, des interrupteurs 29, placés entre les points milieux 25 des bobinages et les super-condensateurs 7, permettent de piloter la connexion des super-condensateurs 7.

Selon un deuxième mode de réalisation, les points milieux des bobinages 23 des trois phases sont reliées à un unique super-condensateur 7 comme décrit sur la figure 9.

Ainsi, avec les modes de réalisation proposés sur les figures 8 et 9, le courant de charge ou de décharge du super-condensateur 7, bien que transitant pas les phases du moteur 5 ne perturbe pas le fonctionnement du moteur 5. En effet, si les courants circulant dans les demi-bobines des phases sont égaux, ils génèrent des forces magnétomotrices qui se compensent, il n'y a donc pas de création de couple.

Les moyens de contrôle du courant de l'onduleur 3 doivent donc veiller au partage équitable des courants de charge et de décharge des super-condensateurs 7.

Ainsi, avec ces configurations, il n'y a pas besoin de convertisseurs supplémentaires 9 dédiés aux super-condensateurs 7, ce qui réduit le coût de l'équipement et le super-condensateur 7 peut être déchargé à zéro de tension ce qui permet une utilisation optimisée.

Afin de mieux comprendre les modes de réalisation de la présente invention, le fonctionnement du circuit d'alimentation va maintenant être décrit en détails dans le cas ou l'équipement mécanique entrainé par le moteur électrique est un véhicule automobile, néanmoins d'autres équipements mécaniques, par exemple de type éolien ou hydraulique, sont visés par la présente invention.

Le fonctionnement consiste essentiellement à piloter, par l'intermédiaire de moyens de contrôle de l'onduleur 3 l'ouverture et la fermeture des moyens de commutations 13 des ponts en H et des interrupteurs 29 afin d'utiliser de façon optimale les super-condensateurs 7.

Selon un aspect de la présente invention, en régime stationnaire (sans accélération ou freinage), la tension au bornes des super-condensateurs 7 est régulée à une valeur intermédiaire entre zéro volt et la valeur E de la tension d'alimentation fournie par la batterie 1, par exemple E/2.

Cette valeur intermédiaire permet aux moyens de contrôle de l'onduleur 3, en cas d'accélération du véhicule, de piloter la décharge des super-condensateurs 7 (éventuellement jusqu'à une tension de zéro volt) afin d'alimenter le moteur électrique 5 ce qui permet de limiter la sollicitation de la batterie 1 et en cas de freinage de récupérer l'énergie fournie par le moteur 5 (qui agit alors comme un générateur) en rechargeant les super-condensateurs 7 (éventuellement jusqu'à une tension E). Lorsque la charge des super-condensateurs 7 correspond à une valeur supérieure à la valeur intermédiaire prédéfinie (E/2 dans le cas présent), les moyens de contrôle ramènent la valeur de la tension aux bornes des super-condensateurs 7 à E/2 en les déchargeant dans la batterie 1 (ceci n'étant pas possible dans le cas d'une pile à combustible puisque la réaction électrochimique est irréversible, dans ce cas, l'énergie récupérée au freinage permet uniquement de recharger les super-condensateurs).

Par ailleurs, dans le cas d'une pile à combustible, l'arrêt de l'alimentation électrique n'est pas immédiat, de sorte que lorsque la commande d'arrêt d'alimentation du moteur est actionnée (en pratique, dans le cas d'un véhicule automobile, cela correspond au relâchement de l'accélérateur), la pile à combustible continue à fournir de l'énergie (régime transitoire). Ainsi, le super-condensateur permet de récupérer cette énergie au lieu de la dissiper sous forme de chaleur. Ainsi l'énergie emmagasinée lors de ce régime transitoire peut être utilisée lors de l'accélération suivante.

Lors d'un trajet urbain par exemple comprenant une alternance d'accélérations et de freinages, l'alimentation du moteur électrique 5 sera faite essentiellement et en priorité par les super-condensateurs 7. Ainsi, la batterie 1 n'est sollicité que très partiellement lors des régimes transitoires, ce qui permet, d'une part de réduire la consommation électrique globale et d'autre part de réduire le vieillissement de la batterie 1.

Par ailleurs, il est possible de contrôler à la fois les courants des super-condensateurs 7 et les courants utiles au moteur 5. Par utile, on entend les courants qui génèrent une force magnétomotrice. En effet, en contrôlant les courants I1 et I2 des demi-bobinage d'une phase du moteur 5 représentés sur la figure 7, on contrôle aussi le courant utile Iu et le courant circulant dans le super-condensateur 7 Ic, les relations entre les courants étant données par les équations suivantes:

$$I_u = \frac{I_1 + I_2}{2}$$

$$I_C = I_2 - I_1$$

Le circuit électrique de la figure 7 peut être modélisé par un modèle moyen dans lequel les bras du pont qui découpent à haute fréquence sont équivalents à une source de tension qui dépend de la tension d'alimentation E et de la valeur moyenne des rapports cycliques $\alpha1$ et $\alpha2$, les valeurs des rapports cycliques étant compris entre 0 et 1. On obtient alors le schéma de la figure 10 dans lequel les sources de tension 31 et 33 délivrent respectivement une tension a1.E et $\alpha2$.E.

Les courants I1 et I2 sont alors définis par

$$I_1 = \frac{\alpha_1 * E - V_C}{Z}$$

$$I_2 = \frac{V_C - \alpha_2 * E}{Z}$$

avec Vc la tension aux bornes du super-condensateur 7 et Z l'impédance d'un demi-bobinage. Les valeurs des courants Iu et Ic sont alors:

$$I_u = \frac{(\alpha_1 - \alpha_2) * E}{Z}$$

$$I_c = \frac{(\alpha_1 - \alpha_2) * E - 2 * V_C}{Z}$$

Ainsi, le courant utile au moteur 5 est contrôlé par la différence des rapports cycliques ($\alpha1 - \alpha2$) alors que le courant dans le super-condensateur 7 est contrôlé par la somme des rapports cycliques ($\alpha1 + \alpha2$). Les deux grandeurs (Iu et Ic) peuvent donc être contrôlées indépendamment, il n'y a pas de couplage entre les deux.

Ainsi, selon un mode de réalisation de la présente invention, les éléments de commutation 13 du pont sont pilotées par deux commandes de modulation de largeur d'impulsions (MLI) dont les rapports cycliques seront calculés pour obtenir le courant désiré dans le moteur 5 et le super-condensateur 7.

Ainsi, l'utilisation d'un moteur 5 dont les bobines 23 des phases sont à point milieu, de ponts en H pour alimenter les bobines 23 et l'implémentation d'un super condensateur 7 entre le point milieu 25 du bobinage 23 et le potentiel de masse 27 du circuit d'alimentation permettent, par le contrôle des éléments de commutation 13 du pont d'utiliser les super-condensateurs 7 sur l'ensemble de leur plage de fonctionnement et notamment leur décharge complète sans utiliser de convertisseur de tension dédié pour chaque super-condensateur 7. Cela permet donc d'optimiser l'application des super-condensateurs 7 dans le circuit d'alimentation et de permettre de réduire, d'une part, les coûts de fabrication puisqu'aucun convertisseur supplémentaire 11 n'est nécessaire et d'autre part les coûts d'utilisation puisque la consommation électrique de la batterie 1 est réduite et son temps de vie est rallongé par la réduction du nombre de cycles de charge et de décharge notamment en conduite urbaine.

**Revendications**

1. Dispositif électrique d'entraînement d'un équipement mécanique comportant un moteur à courant alternatif (5) et un onduleur (3), ledit onduleur (3) comprenant, pour chaque phase dudit moteur (5), une structure de pont en H comportant quatre éléments de commutation (13) répartis sur deux bras (15) reliant deux bornes (21) de ladite structure de pont en H et destinée à alimenter le bobinage (23) de ladite au moins une phase du moteur, ledit bobinage (23) étant un bobinage à point milieu et ledit dispositif électrique étant **caractérisé en ce qu'**il comprend également au moins une unité de stockage d'énergie, notamment un super-condensateur (7), reliée d'une part à au moins une phase du moteur (5) via le point milieu (25) du bobinage (23) de celle-ci et d'autre part à une borne (21) de la structure de pont en H alimentant ledit bobinage (23).

2. Dispositif électrique selon la revendication 1 **caractérisé en ce que** la borne (21) de la structure de pont en H à laquelle l'unité de stockage d'énergie (7) est reliée correspond à la borne reliée au potentiel de masse (27).

3. Dispositif selon la revendication 1 ou 2, **caractérisé en ce que** le dispositif comprend une unique unité de stockage d'énergie (7) reliée d'une part au point milieu (25) du bobinage (23) de chaque phase du moteur (5) et d'autre part à ladite borne (21) de la structure de pont en H alimentant ledit bobinage (23).

4. Dispositif selon la revendication 1 ou 2, **caractérisé en ce que** le dispositif comprend pour chaque phase une unité de stockage d'énergie (7) reliée d'une part au point milieu (25) du bobinage (23) de ladite phase du moteur (5) et d'autre part à ladite borne (21) de la structure de pont en H alimentant ledit bobinage (23).

5. Dispositif électrique selon l'une quelconque des revendications 1 à 4 **caractérisé en ce que** l'unité de stockage d'énergie (7) est un super-condensateur à double couche électrochimique.

6. Dispositif électrique selon l'une des revendications précédentes dans lequel le moteur est alimenté par une pile à combustible.

7. Dispositif électrique selon la revendication 6 dans lequel, lors du régime transitoire correspondant à l'arrêt de l'alimentation du moteur, l'énergie fournie par la pile à combustible est emmagasinée dans l'unité de stockage d'énergie.

8. Dispositif électrique selon l'une des revendications 1 à 5 comprenant également des moyens d'accumulation permettant d'alimenter le moteur et des moyens de contrôle de l'onduleur (3) configurés pour permettre d'une part le chargement de l'unité de stockage d'énergie (7) lors des phases de freinage du véhicule et d'autre part le déchargement de l'unité de stockage d'énergie (7) vers le moteur (5) lors des phases d'accélération ou vers les moyens d'accumulation de manière à charger les moyens d'accumulation.

9. Dispositif électrique selon la revendication 8 **caractérisé en ce que** les moyens d'accumulation comprennent une batterie (1).

10. Dispositif électrique selon l'une des revendications précédentes **caractérisé en ce qu'**un élément de commutation (13) comprend un transistor et une diode montés en parallèle.

11. Dispositif électrique selon la revendication 10 **caractérisé en ce que** le transistor est un transistor bipolaire à porte isolée.

12. Dispositif électrique selon l'une des revendications précédentes **caractérisé en ce que** le moteur à courant alternatif (5) est un moteur triphasé.

13. Procédé de récupération de l'énergie électrique produite par un moteur électrique (5) de véhicule automobile dont chaque phase comprend un bobinage (23) à point milieu et est alimentée par une structure de pont en H, dans lequel, lors des phases de freinage dudit véhicule, les éléments de commutation (13) de la structure de pont en H sont pilotées de manière à récupérer l'énergie électrique produite dans au moins une unité de stockage d'énergie (7), notamment un super-condensateur (7), branchée entre au moins une phase du moteur via le point milieu (25) du bobinage de celle-ci et une borne (21) de la structure de pont en H correspondant au potentiel de masse de la structure de pont en H.

**14.** Procédé de récupération selon la revendication 13 **caractérisé en ce que**, lorsque l'unité de stockage d'énergie (7) est chargée, les éléments de la structure en H sont pilotés de manière à décharger une partie de l'énergie de la ou des unités de stockage d'énergie (7) dans une batterie (1).

**15.** Procédé de restitution de l'énergie électrique emmagasinée dans au moins une unité de stockage d'énergie (7), notamment un super-condensateur (7), à un moteur électrique (1) de véhicule automobile dont chaque phase comprend un bobinage à point milieu et est alimentée par une structure de pont en H dans lequel lors des phases d'accélération dudit véhicule, les éléments de commutation (13) de la structure de pont en H sont pilotées de manière à utiliser en priorité l'énergie emmagasinée dans l'unité de stockage d'énergie (7) qui est branchée entre au moins une phase du moteur (5) via le point milieu du bobinage (23) de celle-ci et une borne de la structure de pont en H correspondant au potentiel de masse de la structure de pont en H.

## Claims

**1.** Electric device for driving mechanical equipment comprising an alternating current motor (5) and an inverter (3), the said inverter (3) comprising, for each phase of the said motor (5), an H bridge structure comprising four switching elements (13) distributed over two branches (15) connecting two terminals (21) of the said H bridge structure and intended to supply the winding (23) of the said at least one phase of the motor, the said winding (23) being a winding with a mid point and the said electric device being **characterized in that** it also comprises at least one energy storage unit, in particular a supercondenser (7), connected, on the one hand, to at least one phase of the motor (5) via the mid point (25) of the winding (23) of which phase and, on the other hand, to a terminal (21) of the H bridge structure supplying the said winding (23).

**2.** Electric device according to Claim 1, **characterized in that** the terminal (21) of the H bridge structure to which the energy storage unit (7) is connected corresponds to the terminal connected to the earth potential (27).

**3.** Device according to Claim 1 or 2, **characterized in that** the device comprises a single energy storage unit (7) connected, on the one hand, to the mid point (25) of the winding (23) of each phase of the motor (5) and, on the other hand, to the said terminal (21) of the H bridge structure supplying the said winding (23).

**4.** Device according to Claim 1 or 2, **characterized in that** the device comprises an energy storage unit (7) for each phase connected, on the one hand, to the mid point (25) of the winding (23) of the said phase of the motor (5) and, on the other hand, to the said terminal (21) of the H bridge structure supplying the said winding (23).

**5.** Electric device according to any one of Claims 1 to 4, **characterized in that** the energy storage unit (7) is an electrochemical double layer supercondenser.

**6.** Electric device according to any one of the preceding claims, **characterized in that** the motor is supplied by a fuel cell.

**7.** Electric device according to Claim 6, **characterized in that**, during the transient conditions corresponding to the stoppage of the power supply of the motor, the energy supplied by the fuel cell is stored in the energy storage unit.

**8.** Electric device according to one of Claims 1 to 5 also comprising accumulation means making it possible to supply the motor and means of control of the inverter (3) configured in order to allow, on the one hand, the charging of the energy storage unit (7) during braking phases of the vehicle and, on the other hand, the discharging of the energy storage unit (7) into the motor (5) during acceleration phases or into the accumulation means in such a way as to charge the accumulation means.

**9.** Electric device according to Claim 8, **characterized in that** the accumulation means comprise a battery (1).

**10.** Electric device according to one of the preceding claims, **characterized in that** the switching element (13) comprises a transistor and a diode connected in parallel.

**11.** Electric device according to Claim 10, **characterized in that** the transistor is an insulated gate bipolar transistor.

**12.** Electric device according to one of the preceding claims, **characterized in that** the alternating current motor (5) is a three-phase motor.

**13.** Method of retrieving the electrical energy produced by an electric motor (5) of a motor vehicle each phase of which comprises a winding (23) with a mid point and is supplied by an H bridge structure, in which, during braking phases of the said vehicle, the switching elements (13) of the H bridge structure are controlled in such a way as to retrieve the electrical energy produced in at least one energy storage unit (7), in particular a supercondenser (7), connected between at least one phase of the motor via the mid point (25) of the winding of which phase and a terminal (21) of the H bridge structure corresponding to the earth potential of the H bridge structure.

14. Retrieving method according to Claim 13, **characterized in that**, when the energy storage unit (7) is charged, the elements of the H structure are controlled in such a way as to discharge a portion of the energy of the energy storage unit or units (7) into a battery (1).

15. Method of retrieving the electrical energy stored in at least one energy storage unit (7), in particular a supercondenser (7), to a motor vehicle electric motor (5) of which each phase comprises a winding with a mid point and is supplied by an H bridge structure in which, during acceleration phases of the said vehicle, the switching elements (13) of the H bridge structure are controlled in such a way as to use, by priority, the energy stored in the energy storage unit (7) which is connected between at least one phase of the motor (5) via the mid point of the winding (23) of which phase and a terminal of the H bridge structure corresponding to the earth potential of the H bridge structure.

**Patentansprüche**

1. Elektrische Antriebsvorrichtung einer mechanischen Ausrüstung, die einen Wechselstrommotor (5) und einen Wechselrichter (3) aufweist, wobei der Wechselrichter (3) für jede Phase des Motors (5) einen H-Brükken-Aufbau enthält, der vier Schaltelemente (13) aufweist, die auf zwei Arme (15) verteilt sind, die zwei Klemmen (21) des H-Brücken-Aufbaus verbinden, und der dazu bestimmt ist, die Wicklung (23) der mindestens einen Phase des Motors zu speisen, wobei die Wicklung (23) eine Wicklung mit Mittelpunkt ist, und die elektrische Vorrichtung **dadurch gekennzeichnet ist, dass** sie ebenfalls mindestens eine Energiespeichereinheit, insbesondere einen Superkondensator (7), enthält, die einerseits mit mindestens einer Phase des Motors (5) über den Mittelpunkt (25) von deren Wicklung (23) und andererseits mit einer Klemme (21) des H-Brükken-Aufbaus verbunden ist, der die Wicklung (23) speist.

2. Elektrische Vorrichtung nach Anspruch 1, **dadurch gekennzeichnet, dass** die Klemme (21) des H-Brücken-Aufbaus, mit der die Energiespeichereinheit (7) verbunden ist, der Klemme entspricht, die mit dem Massepotential (27) verbunden ist.

3. Vorrichtung nach Anspruch 1 oder 2, **dadurch ge-**

**kennzeichnet, dass** die Vorrichtung eine einzige Energiespeichereinheit (7) enthält, die einerseits mit dem Mittelpunkt (25) der Wicklung (23) jeder Phase des Motors (5) und andererseits mit der Klemme (21) des H-Brücken-Aufbaus verbunden ist, der die Wicklung (23) speist.

4. Vorrichtung nach Anspruch 1 oder 2, **dadurch gekennzeichnet, dass** die Vorrichtung für jede Phase eine Energiespeichereinheit (7) enthält, die einerseits mit dem Mittelpunkt (25) der Wicklung (23) der Phase des Motors (5) und andererseits mit der Klemme (21) des H-Brücken-Aufbaus verbunden ist, der die Wicklung (23) speist.

5. Elektrische Vorrichtung nach einem der Ansprüche 1 bis 4, **dadurch gekennzeichnet, dass** die Energiespeichereinheit (7) ein Superkondensator mit doppelter elektrochemischer Schicht ist.

6. Elektrische Vorrichtung nach einem der vorhergehenden Ansprüche, **dadurch gekennzeichnet, dass** der Motor von einer Brennstoffzelle gespeist wird.

7. Elektrische Vorrichtung nach Anspruch 6, bei der im Übergangszustand, der dem Abschalten der Speisung des Motors entspricht, die von der Brennstoffzelle gelieferte Energie in der Energiespeichereinheit gespeichert wird.

8. Elektrische Vorrichtung nach einem der Ansprüche 1 bis 5, die ebenfalls Speichereinrichtungen, die es ermöglichen, den Motor zu speisen, und Steuereinrichtungen des Wechselrichters (3) enthält, die konfiguriert sind, um einerseits das Laden der Energiespeichereinheit (7) in den Bremsphasen des Fahrzeugs und andererseits das Entladen der Energiespeichereinheit (7) zum Motor (5) in den Beschleunigungsphasen oder zu den Speichereinrichtungen zu erlauben, um die Speichereinrichtungen zu laden.

9. Elektrische Vorrichtung nach Anspruch 8, **dadurch gekennzeichnet, dass** die Speichereinrichtungen eine Batterie (1) enthalten.

10. Elektrische Vorrichtung nach einem der vorhergehenden Ansprüche, **dadurch gekennzeichnet, dass** ein Schaltelement (13) einen Transistor und eine Diode enthält, die parallel geschaltet sind.

11. Elektrische Vorrichtung nach Anspruch 10, **dadurch gekennzeichnet, dass** der Transistor ein Bipolartransistor mit isoliertem Gatter ist.

12. Elektrische Vorrichtung nach einem der vorhergehenden Ansprüche, **dadurch gekennzeichnet, dass** der Wechselstrommotor (5) ein Drehstrommotor ist.

13. Verfahren zur Gewinnung der von einem Elektromotor (5) eines Kraftfahrzeugs erzeugten elektrischen Energie, von dem jede Phase eine Wicklung (23) mit Mittelpunkt enthält und von einem H-Brücken-Aufbau gespeist wird, bei dem in den Bremsphasen des Fahrzeugs die Schaltelemente (13) des H-Brücken-Aufbaus so gesteuert werden, dass sie die erzeugte elektrische Energie in mindestens einer Energiespeichereinheit (7), insbesondere einem Superkondensator (7), gewinnen, die zwischen mindestens einer Phase des Motors über den Mittelpunkt (25) von dessen Wicklung und einer Klemme (21) des H-Brücken-Aufbaus angeschlossen ist, die dem Massenpotential des H-Brücken-Aufbaus entspricht.

14. Gewinnungsverfahren nach Anspruch 13, **dadurch gekennzeichnet, dass**, wenn die Energiespeichereinheit (7) geladen ist, die Elemente des H-Aufbaus so gesteuert werden, dass ein Teil der Energie der Energiespeichereinheit(en) (7) in eine Batterie (1) entladen wird.

15. Verfahren zur Abgabe der in mindestens einer Energiespeichereinheit (7), insbesondere einem Superkondensator (7), gespeicherten elektrischen Energie an einen Elektromotor (1) eines Kraftfahrzeugs, von dem jede Phase eine Wicklung mit Mittelpunkt enthält und von einem H-Brücken-Aufbau gespeist wird, wobei in den Beschleunigungsphasen des Fahrzeugs die Schaltelemente (13) des H-Brücken-Aufbaus so gesteuert werden, dass prioritär die in der Energiespeichereinheit (7) gespeicherte Energie verwendet wird, die zwischen mindestens einer Phase des Motors (5) über den Mittelpunkt von deren Wicklung (23) und einer Klemme des H-Brücken-Aufbaus angeschlossen ist, die dem Massepotential des H-Brücken-Aufbaus entspricht.

Fig.1

Fig.2

Fig.3

Fig.4

Fig.5

Fig.6

Fig.7

Fig.8

Fig.9

Fig.10

**RÉFÉRENCES CITÉES DANS LA DESCRIPTION**

**Documents brevets cités dans la description**

- EP 1241041 A